# EUROPEAN PATENT APPLICATION

(11) **EP 4 492 929 A1**
(43) Date of publication of application: **15.01.2025**
(21) Application number: 24183892.9
(22) Date of filing: 24.06.2024
(51) Int. Cl.: H05K 5/00, H05K 9/00

(54) **CONTROL UNIT AND STEERING CONTROL SYSTEM**

(30) Priority: 14.07.2023 CN 202310869773
(71) Applicant: Robert Bosch GmbH, 70442 Stuttgart (DE)
(72) Inventor: LIU, Olina, Jiangsu, 215021 (CN)

(57) **Abstract**

The present application provides a control unit and a steering control system. The control unit comprises a shield, including a body comprising an edge and enclosing an internal cavity; a plurality of elastic structures, distributed along the edge and extending in a direction away from the cavity; a cover, comprising a bent portion that protrudes towards the shield and with an end in contact with the elastic structure, causing the elastic structure to deform at least partially; and a circuit board, disposed between the shield and the cover, and insulated from the shield and the cover. The control unit and steering control system of the present application offer advantages such as simplicity of structure, ease of application, and good safety performance.

## Description

### Technical Field

The present application relates to the field of electromagnetic shielding structures. More specifically, the present application relates to a control unit intended to provide improved mechanical connection. The present application also relates to a steering control system comprising the control unit as described above.

### Background Art

The ECU is also referred to as an electronic control unit. An ECU typically comprises a circuit board that provides the desired control functions. For ECUs operating under harsh working conditions, certain electromagnetic shielding capabilities are necessary. Electromagnetic shielding capabilities are generally provided by a shield or shielding housing. The shield and the shielding housing need to be connected together, for example, through a hard connection method. Typical hard connection methods may include bolt connections and the like. Such connections typically result in significant counteracting forces and may require additional installation space, thereby complicating the manufacturing process and increasing manufacturing costs.

### Summary of the Invention

It is an aim of one aspect of the present application to provide a control unit that is intended to offer an improved solution for electromagnetic shielding and mechanical connection. It is an aim of another aspect of the present application to provide a steering control system comprising the control unit as described above.

The aims of the present application are achieved through the following technical solutions:
A control unit comprising:
a shield, including
a body comprising an edge and enclosing an internal cavity; and
a plurality of elastic structures distributed along an edge and extending in a direction away from the cavity;
a cover, comprising a bent portion that protrudes towards the shield and with an end in contact with the elastic structure, causing the elastic structure to deform at least partially; and
a circuit board, disposed between the shield and the cover, and insulated from the shield and the cover.

In the control unit described above, optionally, the elastic structure comprises at least a first portion and a second portion, wherein the first portion extends perpendicularly to the edge and away from the cavity, and the second portion extends horizontally relative to the edge; the bent portion contacts the second portion of the elastic structure.

In the above control unit, optionally, the elastic structure further comprises a third portion that is connected between the first portion and the second portion, such that the outer contours of the first portion, the third portion, and the second portion are smoothly transitioned, and the side profile of the elastic structure has a contour that is one of the following shapes: a portion of the letter "C", a portion of a circle, a portion of an ellipse, or a combination thereof.

In the control unit described above, optionally, the body comprises an opening, the edge includes the opening, and the cavity is communicated with the outside through the opening.

In the above control unit, optionally, the second portion is disposed at one or more of the following positions: the space above the opening, the space outside the space above the opening, or the space above the edge.

In the control unit described above, optionally, the body further comprises a plurality of process holes, each process hole extending through the body respectively and corresponding to the elastic structure, disposed below the second portion; wherein the process hole is configured to have one of the following shapes: triangle, rectangle, rhombus, trapezoid, circle, ellipse, pentagon, hexagon, or a combination thereof.

In the above control unit, optionally, the body and the elastic structure are integrally formed, and the shield and the cover are made of one of the following materials: aluminum alloy, copper alloy, iron, steel, or a combination thereof.

In the above control unit, optionally, the side profile of the bent portion has a contour that is one of the following shapes: U-shaped, L-shaped, step-shaped, or a combination thereof, and the elastic structure contacts the end of the bent portion.

A steering control system comprising
a housing made of an insulating material;
the control unit described above positioned at one end of the housing, wherein the cover further comprises a recess, being disposed between the outer contour of the cover and the bent portion, matching the end contour of the housing, and being bonded to the end of the housing, wherein the shield is disposed between the cover and the housing; and a motor is disposed within the housing.

In the steering control system described above, optionally, it further comprises an electrical connector, which is disposed side by side a motor near the control unit, wherein the electrical connector provides electrical connection to the control unit, and the control unit electrically connects and operates the motor.

### Description of Accompanying Drawings

The present application will be described in further detail below in conjunction with the accompanying drawings and preferred examples. It will be appreciated by those skilled in the art that these accompanying drawings are drawn for purposes of interpreting preferred examples only, and therefore should not be construed as limiting the scope of the present application. In addition, unless otherwise specified, the accompanying drawings are intended purely to conceptually represent the composition or construction of the described objects and may include exaggerated representations. The accompanying drawings are also not necessarily to scale.
FIG. 1 is a stereoscopic view of one example of a shield of the present application.
FIG. 2 is a partially enlarged view of the A1 portion of FIG. 1.
FIG. 3 is a partial cross-sectional view of one example of a steering control system of the present application.
FIG. 4 is a partially enlarged view of the A2 portion of FIG. 3.

### Specific Embodiments

Preferred examples of the present application will be described in detail below with reference to the accompanying drawings. It will be appreciated by those skilled in the art that these descriptions are purely descriptive, exemplary, and should not be construed as limiting the scope of protection of the present application.

First, it should be noted that the terms top, bottom, upward, downward, and other orientation terms referred to herein are defined relative to the orientations in each of the accompanying drawings. These orientations are relative concepts and therefore will vary based on their respective positions and states. Therefore, these or other orientation terms should not be construed as limiting.

In addition, it should be noted that for any single technical feature described or implied in the examples herein or shown or implied in the accompanying drawings, these technical features (or equivalent thereof) can be combined to obtain other examples not explicitly mentioned herein.

It should be noted that in different drawings, the same reference numbers represent the same or substantially similar components.

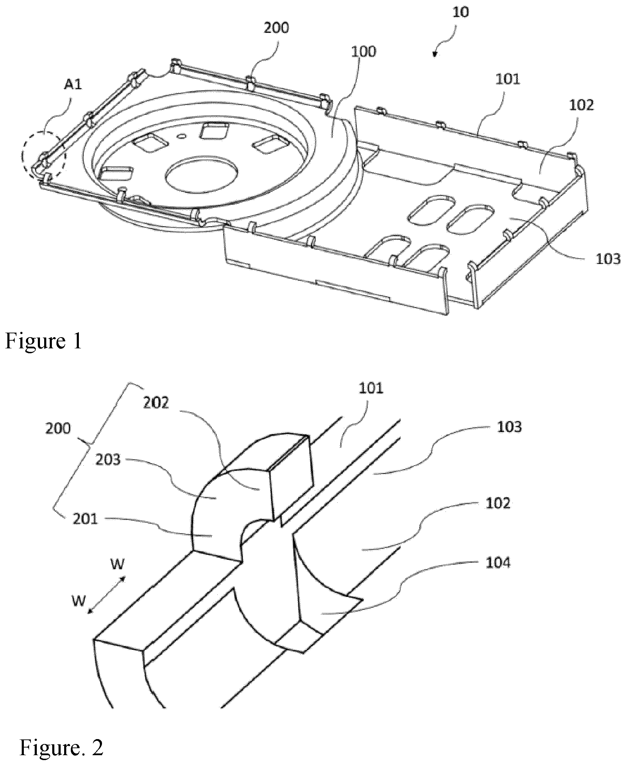

FIG. 1 is a stereoscopic view of one example of a shield of the present application, and FIG. 2 is a partially enlarged view of the A1 portion of FIG. 1. The shield 10 may include a body 100 and a plurality of elastic structures 200. The body 100 and the plurality of elastic structures 200 may be integrally formed, for example, through machining methods such as stamping. In one example, the shield 10 may be made of metal. In one example, the shield 10 may be made of one of the following materials: iron, steel, aluminum alloy, copper alloy, or a combination thereof.

The body 100 may have any suitable structure. In the example shown in FIGS. 1 and 2, the contour of the body 100 is designed to accommodate the circuit board, which is not shown. The circuit board, for example, may be rectangular, and the body 100 may include a cavity 102 to accommodate the circuit board. The edge 101 of the body 100 extends around the perimeter of the cavity 102. In one example, the edge 101 surrounds the cavity 102, and the shape of the cavity 102 may be configured according to actual requirements, such as based on the contour of the housing of the steering control system. In one example, the edge 101 of the body 100 may be substantially flush. In other words, the entire edge 101 may be substantially located on the same plane. In the example shown in FIG. 1, the entire edge 101 may be substantially located on a horizontal plane, with the space occupied by the cavity 102 below the horizontal plane and the space away from the cavity 102 above the horizontal plane. In one example, the elastic structure 200 may be positioned above the horizontal plane described above. Above the cavity 102, there is an opening 103, which can be considered as the open space within the contour surrounded by the edge 101. The cavity 102 is communicated with the outside through the opening 103.

The plurality of elastic structures 200 may be distributed along the edge 101. In one example, the elastic structures 200 may be spaced apart from one another. For example, in the width direction W-W as shown in FIG. 2, each elastic structure 200 may have a width of approximately 1 - 5 mm, such as 2 mm, 3 mm, or 4 mm. In the illustrated example, the elastic structure 200 extends in a direction away from the cavity 102. In one example, the elastic structures 200 may have a wider width, for example, they may extend between adjacent elastic structures 200 as shown in FIG. 1.

More specifically, as shown in FIG. 2, the elastic structure 200 may comprise a first portion 201, a second portion 202, and a third portion 203. The first portion 201 may extend perpendicularly to the edge 101. Or, the first portion 201 may extend perpendicularly to the plane where the edge 101 is located. The second portion 202 may extend horizontally relative to the edge 101, or, it may extend parallel or horizontally relative to the plane where the edge 101 is located. The third portion 203 is connected between the first portion 201 and the second portion 202. In one example, the contours of the first portion 201, the second portion 202, and the third portion 203 are continuous and smoothly transitioned. As shown in FIG. 2, when viewed from the width direction W-W, the first portion 201, the second portion 202, and the third portion 203 form the side profile of the elastic structure 200. The side profile may have one of the following shapes: a portion of the letter "C", a portion of a circle, a portion of an ellipse, or a combination thereof. The side profile of the elastic structure 200 is designed to allow it to deform partially under pressure, thus providing elastic force and support capability.

The first portion 201, the second portion 202, and the third portion 203 may have consistent width dimensions in the width direction W-W. In one example, the cross-sectional profile of the elastic structure 200 along its extension direction may be rectangular, for example, square.

It should be noted that the example shown in FIG. 2 is just one example of the elastic structure 200. In FIG. 2, the second portion 202 extends above the cavity 102 or opening 103. In fact, the second portion 202 may be positioned at different locations, such as above the edge 101, above the cavity 102 or opening 103, outside the space above the opening 103, and the like. In one example, the second portion 202 may be disposed at one or more of these locations mentioned above.

As shown in FIG. 2, the body 100 may also include a plurality of process holes 104. The process holes 104 may be disposed below the second portion 202 and extend through the body 100. A single process hole 104 may correspond to a single elastic structure 200. During the machining process, the machining tool may pass through the process hole 104 and reach the elastic structure 200, allowing the elastic structure 200 to be easily bent and formed. As shown in FIG. 1, at least a portion of the multiple elastic structures 200 may have corresponding process holes, and a portion of the elastic structure 200 may be positioned above structural holes or other penetrations on the body 100, thereby eliminating the need for separate process holes. In FIG. 2, the process hole 104 is configured to be substantially rectangular. In one example, the process hole 104 may be configured to have one of the following shapes: triangle, rectangle, rhombus, trapezoid, circle, ellipse, pentagon, hexagon, or a combination thereof. In one example, the dimensions of the process hole 104 may be larger than those of the elastic structure 200. For example, in the width direction W-W, the width of the process hole 104 may be greater than that of the elastic structure 200.

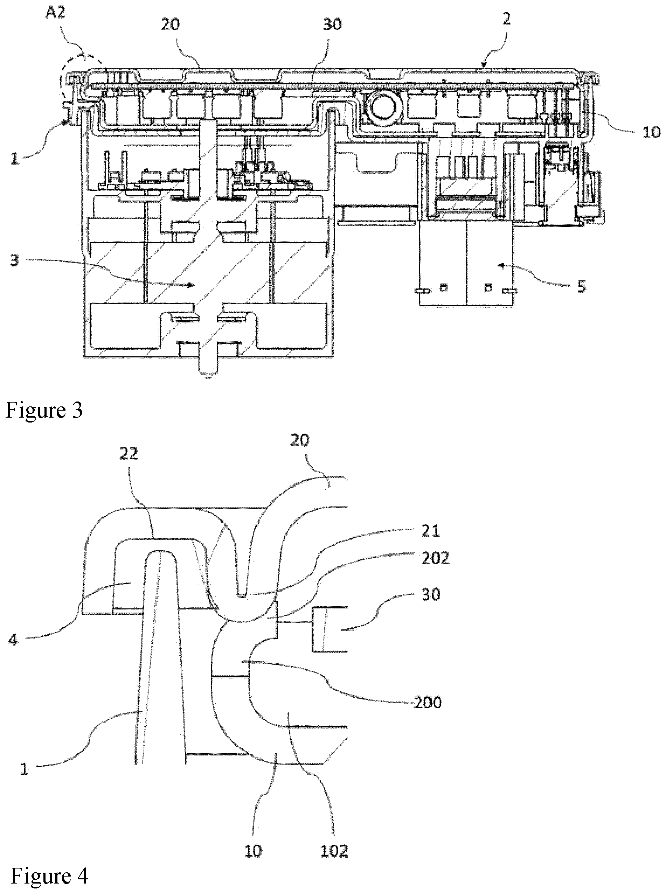

FIG. 3 is a partial cross-sectional view of one example of a steering control system of the present application, and FIG. 4 is a partial enlarged view of the A2 portion of FIG. 3. The steering control system may comprise: housing 1, control unit 2, motor 3, and so on. For the sake of clarity, some components of the steering control system may be omitted from FIG. 3, focusing on clearly showing components such as housing 1, control unit 2, and motor 3. The motor 3 may be accommodated within the housing 1, providing protection for the motor 3. The control unit 2 may be disposed at one end of the housing 1. As shown in the figure, the motor 3 and the electrical connector 5 are disposed side by side, with the control unit 2 disposed on one side of the motor 3 and the electrical connector 5. The electrical input from the electrical connector 5 is first directed to the control unit 2, which then controls the motor 3. In the perspective shown in FIG. 3, the control unit 2, motor 3, and electrical connector 5 are disposed at the three vertices of a virtual triangle, and the electrical connection and transmission sequence is: from the electrical connector 5 to the control unit 2 to the motor 3.

The control unit 2 may comprise: the shield 10, cover 20, and circuit board 30 as described above, among others. The cover 20 may have a shape that matches the shield 10. For example, the cover 20 may include a bent portion 21 and a recess 22. The bent portion 21 and the recess 22 may be formed by a bending process and extend along an edge of the cover 20. In one example, during the machining of the recess 22, the bent portion 21 may be incidentally formed. The bent portion 21 may be a section of the main body of the cover 20 bent at a significant angle, and the protrusion direction of the recess 22 and the bent portion 21 may be opposite. In one example, the recess 22 is adjacent to the bent portion 21 to ensure sufficient structural strength. In one example, the side profile of the bent portion 21 may have a contour that is one of the following shapes: U-shaped, L-shaped, step-shaped, or a combination thereof. In the illustrated example, the recess 22 is located between the bent portion 21 and the outer contour of the cover 20. The bent portion 21 may be positioned to correspond to the elastic structures 200 of the shield 10 and in contact with the second portion 202 of the elastic structures 200. In other words, as shown in FIG. 4, an end or lower portion of the bent portion 21 may be in contact with the elastic structures 200. The bent portion 21 of FIG. 4 is substantially U-shaped. For an L-shaped or step-shaped bent portion, the elastic structures 200 may make contact with the flat surface of the lower part of the L-shaped or step-shaped bent portion. The recess 22 may correspond to an end contour of the housing 1 and may be bonded to the end contour of the housing 1. Reference numeral 4 in FIG. 2 indicates the adhesive located between the recess 22 and the housing 1.

During installation, the circuit board 30 is positioned between the shield 10 and the cover 20, and is electrically insulated from both the shield 10 and the cover 20, or, electrically spaced apart. In one example, the cover 20 may be made of metal, for example, it may be made of one of the following materials: iron, steel, aluminum alloy, copper alloy, or a combination thereof. The combination of the cover 20 and the shield 10 will provide electromagnetic shielding capability for the circuit board 30. At the same time, the cover 20 contacts the shield 10 through the second portion 202 of the elastic structure 200, and the cover 20 is also connected to the housing 1 via adhesive 4, exerting force on the shield 10. Under this force, the second portion 202 of the elastic structure 200 is deformed at least partially, providing a connection structure with certain elasticity and electromagnetic shielding structure.

In one example, the outer contour dimensions of the shield 10 are smaller than those of the cover 20, and the shield 10 is positioned between the cover 20 and the housing 1. In one example, the dimensions of the circuit board 30 are smaller than those of the shield 10. The circuit board 30 may be constructed in a rectangular shape and have a planar form. The circuit board 30 may host a variety of electronic components, including controllers, capacitors, and coils, required by the control unit. The combination of the cover 20 and the shield 10 will provide electromagnetic shielding capability for these electronic components. At the same time, the shield 10 and the cover 20 also provide physical protection for these electronic components. In the illustrated example, the circuit board 30 may be positioned above the cavity 102 of the shield 10. Furthermore, the circuit board 30 is positioned within a larger cavity surrounded by the shield 10 and the cover 20. The cavity 102 of the shield 10 forms a part of the cavity described above.

The shield, control unit and steering control system of the present application offer advantages such as simplicity and reliability, ease of manufacturing, and good safety performance. By employing the shield, control unit, and steering control system of the present application, the electromagnetic shielding capability of the circuit board is enhanced. Moreover, the control unit of the present application requires less installation space, reducing manufacturing complexity and manufacturing costs as compared to the prior art. The forces generated by the deformation of the elastic structures in the present application are reduced compared to the prior art, thereby reducing manufacturing difficulties.

This specification discloses the present application with reference to the accompanying drawings and also enables those skilled in the art to implement the present application, including the manufacture and use of any device or system, the selection of suitable materials, and the use of any combination of methods. The scope of the present application is defined by the technical solutions for which protection is sought and includes other embodiments that may be conceivable to those skilled in the art. As long as such other embodiments comprise structural elements that do not differ from the literal description of the technical solutions for which protection is sought or comprise equivalent structural elements that do not substantially differ from the literal description of the technical solutions for which protection is sought, such other embodiments should be considered within the scope of protection defined by the technical solutions for which protection is sought under the present application.

## Claims

1. A control unit **characterized in that** it comprises
a shield (10), comprising:
a body (100) including an edge (101) and enclosing an internal cavity (102); and
a plurality of elastic structures (200), which are distributed along the edge (101) and extend in a direction away from the cavity (102);
a cover (20), comprising a bent portion (21) that protrudes towards the shield (10) and with an end in contact with the elastic structure (200), causing the elastic structure (200) to deform at least partially; and a circuit board (30), disposed between the shield (10) and the cover (20), and insulated from the shield (10) and the cover (20).

2. The control unit according to Claim 1, **characterized in that** the elastic structure (200) comprises at least a first portion (201) and a second portion (202), wherein the first portion (201) extends perpendicularly to the edge (101) and away from the cavity (102), and the second portion (202) extends horizontally relative to the edge (102); the bent portion (21) contacts the second portion (202) of the elastic structure (200).

3. The control unit according to Claim 2, **characterized in that** the elastic structure (200) further comprises a third portion (203) that is connected between the first portion (201) and the second portion (202), such that the outer contours of the first portion (201), the third portion (203), and the second portion (202) are smoothly transitioned, and the side of the elastic structure (200) has a contour that is one of the following shapes: a portion of the letter "C", a portion of a circle, a portion of an ellipse, or a combination thereof.

4. The control unit according to Claim 2, **characterized in that** the body comprises an opening (103), the edge (101) includes the opening (103), and the cavity (102) is communicated with the outside through the opening (103).

5. The control unit according to Claim 4, **characterized in that** the second portion (202) is disposed at one or more of the following positions: the space above the opening (103), the space outside the space above the opening (103), or the space above the edge (101).

6. The control unit according to any one of Claims 1-5, **characterized in that** the body (100) further comprises a plurality of process holes (104), each process hole (104) extending through the body (100) respectively and corresponding to the elastic structure (200), disposed below the second portion (202); wherein the process hole (104) is configured to have one of the following shapes: triangle, rectangle, rhombus, trapezoid, circle, ellipse, pentagon, hexagon, or a combination thereof.

7. The control unit according to any one of Claims 1-5, **characterized in that** the body (100) and the elastic structure (200) are integrally formed, and the shield (10) and the cover (20) are made of one of the following materials: aluminum alloy, copper alloy, iron, steel, or a combination thereof.

8. The control unit according to any one of Claims 1 - 5, **characterized in that** the side profile of the bent portion (21) has a contour that is one of the following shapes: U-shaped, L-shaped, step-shaped, or a combination thereof, and the elastic structure (200) contacts the end of the bent portion (21).

9. A steering control system, **characterized in that** it comprises:
a housing (1) made of an insulating material;
a control unit (2) according to any one of Claims 1 - 8, positioned at one end of the housing (1), wherein the cover (20) further comprises a recess (22), which is being disposed between the outer contour of the cover (20) and the bent portion (21), matching the end contour of the housing (1), and being bonded to the end of the housing (1), and wherein the shield (10) is disposed between the cover (20) and the housing (1); and a motor (3) is disposed within the housing (1).

10. The steering control system according to Claim 9, **characterized in that** it further comprises an electrical connector (5), which is disposed side by side a motor (3) near the control unit (2), wherein the electrical connector (5) provides electrical connection to the control unit (2), and the control unit (2) electrically connects and operates the motor (3).
